(19) Europäisches Patentamt
European Patent Office
Office européen des brevets

(11) **EP 4 166 297 A1**

(12) **EUROPEAN PATENT APPLICATION**
published in accordance with Art. 153(4) EPC

(43) Date of publication:
**19.04.2023 Bulletin 2023/16**

(21) Application number: **21826497.6**

(22) Date of filing: **03.06.2021**

(51) International Patent Classification (IPC):
**B29B 7/48** (2006.01)    **B29B 7/72** (2006.01)
**B29C 48/285** (2019.01)    **B29C 48/40** (2019.01)
**B29C 48/92** (2019.01)

(52) Cooperative Patent Classification (CPC):
**B29B 7/48; B29B 7/72; B29B 7/80; B29C 48/285;
B29C 48/40; B29C 48/92**

(86) International application number:
**PCT/JP2021/021138**

(87) International publication number:
**WO 2021/256272 (23.12.2021 Gazette 2021/51)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **15.06.2020 JP 2020103154**

(71) Applicant: **The Japan Steel Works, Ltd.
Tokyo 141-0032 (JP)**

(72) Inventors:
• **FUKUZAWA, Yohei
Tokyo 141-0032 (JP)**
• **TOMIYAMA, Hideki
Tokyo 141-0032 (JP)**

(74) Representative: **Cabinet Beaumont
4, Place Robert Schuman
B.P. 1529
38025 Grenoble Cedex 1 (FR)**

(54) **SIMULATION DEVICE, SIMULATION METHOD AND SIMULATION PROGRAM**

(57)     A simulation device for calculating a predetermined physical quantity in a kneading extruder, the simulation device comprises:
an acquisition unit configured to acquire at least a characteristic of a first raw material and a characteristic of a second raw material, the first raw material and the second raw material being injected into the kneading extruder; and a calculation unit configured to calculate a physical quantity of a mixture of the first raw material and the second raw material based on the characteristics of the first raw material and the second raw material acquired by the acquisition unit.

FIG. 3

**Description**

[Technical Field]

The present invention relates to a simulation device, a simulation method, and a simulation program for calculating a predetermined physical quantity in a kneading extruder.

[Background Art]

In a twin-screw type extruder, a screw is segmented in order to assign a degree of freedom to a screw configuration. For example, a screw may be formed by combining a plurality of types of screw pieces, such as a screw piece having a function of transporting a raw material in a forward direction and a screw piece having a function of kneading a raw material. However, it is not easy to determine a screw configuration according to a resin, and there is a problem that trial and error is required.

As a technology for solving this problem, Patent Document 1 discloses a simulation device that predicts a filling rate, a pressure, a temperature, etc. in a biaxial extruder. The simulation device initially sets resin properties such as a viscosity model and a melting point of a resin, which is a raw material, and density, specific heat, and thermal conductivity of a solid and a melted body, extrusion conditions such as an extrusion amount, a screw rotation speed, a resin temperature, a tip resin pressure, and a cylinder temperature, and data indicating a screw configuration, and calculates the filling rate, the pressure, the temperature, etc. in the biaxial extruder based on the initially set data. By using the simulation device, it becomes easy to determine the screw configuration.

[Prior Art Document]

[Patent Document]

[Patent Document 1] Japanese Patent Laid-Open Publication No. 2004-148722

[Summary of Invention]

[Problems to be Solved by Invention]

However, a conventional simulation device predicts a kneading state of a single resin injected from a main hopper, and has a problem in that it is impossible to simulate a kneading process in which different polymers, fillers, etc. are mixed with a plurality of types of raw materials, for example, a main raw material, which is usually performed in an actual process.

An object of the invention is to provide a simulation device, a simulation method, and a simulation program capable of calculating a predetermined physical quantity in a kneading process of a plurality of types of raw materials.

[Means for Solving Problems]

A simulation device of an aspect of the present disclosure is the simulation device for calculating a predetermined physical quantity in a kneading extruder, the simulation device comprising: an acquisition unit configured to acquire at least a characteristic of a first raw material and a characteristic of a second raw material, the first raw material and the second raw material being injected into the kneading extruder; and a calculation unit configured to calculate a physical quantity of a mixture of the first raw material and the second raw material based on the characteristics of the first raw material and the second raw material acquired by the acquisition unit.

A simulation method of an aspect of the present disclosure is the A simulation method for calculating a predetermined physical quantity in a kneading extruder, the simulation method comprising: acquiring at least a characteristic of a first raw material and a characteristic of a second raw material, the first raw material and the second raw material being injected into the kneading extruder; and calculating a physical quantity of a mixture of the first raw material and the second raw material based on the acquired characteristics of the first raw material and the second raw material.

A simulation program of an aspect of the present disclosure is the simulation program for causing a computer to execute a process of calculating a predetermined physical quantity in a kneading extruder, the simulation program causing the computer to execute processes of acquiring at least a characteristic of a first raw material and a characteristic of a second raw material, the first raw material and the second raw material being injected into the kneading extruder; and calculating a physical quantity of a mixture of the first raw material and the second raw material based on the acquired characteristics of the first raw material and the second raw material.

[Effects of Invention]

According to the invention, it is possible to calculate a predetermined physical quantity in a kneading process of a plurality of types of raw materials.

[Brief Description of Drawings]

FIG. 1 is a block diagram illustrating a configuration example of a simulation device according to an embodiment.
FIG. 2 is a schematic view illustrating a configuration example of a kneading extruder according to the present embodiment.
FIG. 3 is a flowchart illustrating a simulation method according to the present embodiment.
FIG. 4 is a flowchart illustrating the simulation method according to the present embodiment.
FIG. 5 is a flowchart illustrating the simulation method according to the present embodiment.
FIG. 6 is a graph illustrating a relationship between a mixing ratio and viscosity of a mixture.
FIG. 7 is a graph illustrating a simulation result of a kneading process.
FIG. 8 is a graph illustrating a resin temperature and a dispersed particle diameter of each raw material in the kneading process.
FIG. 9 is a chart illustrating a comparison result between a measured value and a simulation result.
FIG. 10A is an optical micrograph illustrating a dispersed state of a resin raw material.
FIG. 10B is an optical micrograph illustrating a dispersed state of a resin raw material.

[Mode for Carrying out Invention]

Specific examples of a simulation device, a simulation method, and a simulation program according to an embodiment of the invention will be described below with reference to the drawings. It should be noted that the invention is not limited to these examples, and is indicated by the scope of claims, and is intended to include all modifications within the meaning and scope equivalent to the scope of claims. Further, at least a part of the following embodiment and modification may be arbitrarily combined.

Hereinafter, the invention will be specifically described with reference to the drawings illustrating the embodiment thereof.

<Simulation device>

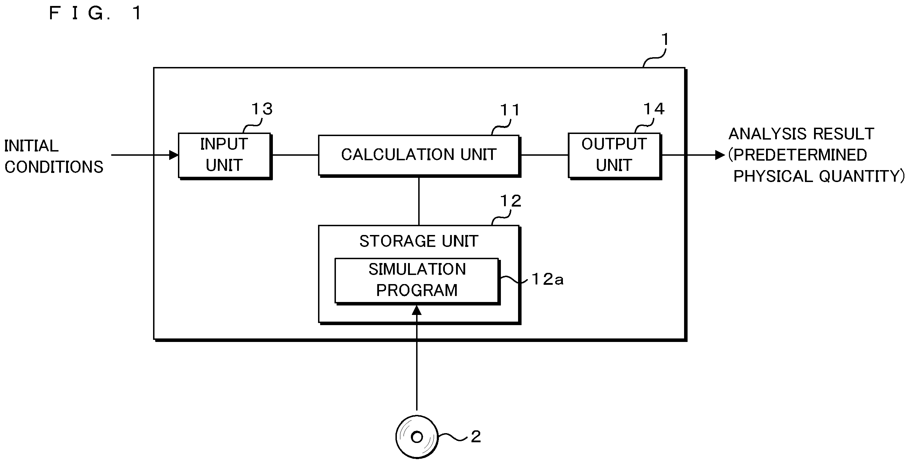

FIG. 1 is a block diagram illustrating a configuration example of a simulation device 1 according to an embodiment. The simulation device 1 according to the present embodiment is a computer that simulates a kneading process in a twin-screw type kneading extruder that kneads a plurality of raw materials, and includes a calculation unit 11, a storage unit 12, an input unit 13, and an output unit 14.

The calculation unit 11 includes an arithmetic circuit such as a CPU (Central Processing Unit), an MPU (Micro-Processing Unit), a GPU (Graphics Processing Unit), a GPGPU (General-purpose computing on graphics processing units), a TPU (Tensor Processing Unit), an ASIC (Application Specific Integrated Circuit), an FPGA (Field-Programmable Gate Array), and an NPU (Neural Processing Unit), internal storage devices such as a ROM (Read Only Memory) and a RAM (Random Access Memory), an I/O terminal, etc. The calculation unit 11 reads and executes a simulation program (program product) 12a stored in the storage unit 12 to perform a process of calculating a predetermined physical quantity in the twin-screw type kneading extruder. Each of the functional units of the simulation device 1 may be realized by software, or some or all thereof may be realized by hardware.

The storage unit 12 is, for example, a storage device such as a hard disk, an EEPROM (Electrically Erasable Programmable ROM), or a flash memory. The storage unit 12 stores various programs executed by the calculation unit 11 and various types of data required for processing by the calculation unit 11. In the present embodiment, the storage unit 12 stores at least the simulation program 12a executed by the calculation unit 11.

The simulation program 12a may be written to the storage unit 12 at a manufacturing stage of the simulation device 1. The simulation program 12a may be distributed by another information processing device, etc. via a network. The simulation device 1 acquires the simulation program 12a by communication and writes the simulation program 12a to the storage unit 12. The simulation program 12a may be recorded to be readable on a recording medium 2 such as a semiconductor memory such as a flash memory, an optical disc, a magneto-optical disc, or a magnetic disk. The simulation device 1 reads the simulation program 12a and stores the simulation program 12a in the storage unit 12.

The input unit 13 is an interface for fetching data from the outside. The input unit 13 is, for example, a keyboard and a mouse, and acquires data related to initial conditions. The data related to the initial conditions is data related to physical properties of a resin which is a raw material, extrusion conditions of the kneading extruder, the screw configuration, etc. Details of the initial conditions will be described later. Note that the input unit 13 may read the data of the initial conditions from a storage device (not illustrated) or receive the data from another computer.

The output unit 14 is a display device such as a liquid crystal display panel or an organic EL display panel. The output unit 14, which is a display device, displays a predetermined physical quantity in the kneading extruder based on analysis result data output from the calculation unit 11. The predetermined physical quantity is, for example, a residence time of a mixed material in the kneading extruder, a filling rate, a temperature, a dispersed particle diameter, etc. Note that the display device is an example of the output unit 14, and may be a printer, a communication device that transmits an analysis result to an external terminal, etc. as long as the device outputs the analysis result to the outside.

Note that the simulation device 1 described above may be a multi-computer device including a plurality of computers, or may be a virtual machine virtually constructed by software. Further, the simulation device 1 may be configured as a cloud server.

<Kneading extruder>

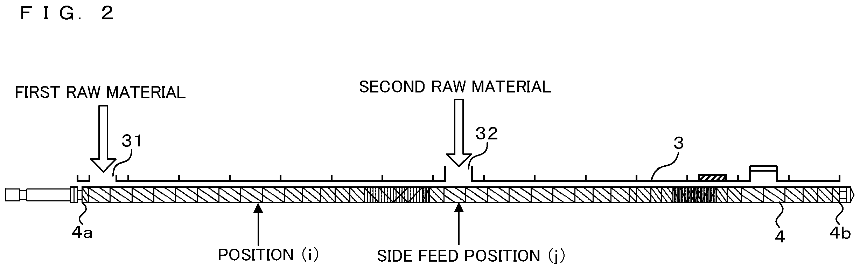

FIG. 2 is a schematic view illustrating a configuration example of the kneading extruder according to the present embodiment. The kneading extruder to be simulated includes a screw 4 for melting and kneading a plurality of raw materials, and a cylinder 3 into which the screw 4 is rotatably inserted.

The cylinder 3 includes a hopper (first injection portion) 31 into which a first raw material is injected, and a side feed (second injection portion) 32 into which a second raw material is injected. The hopper 31 is arranged on a root side (left side in FIG. 2), and the side feed 32 is arranged on an outlet side of the cylinder 3 with respect to the hopper 31.

The screw 4 is configured as one screw 4 by combining and integrating a plurality of types of screw pieces. For example, the screw 4 is configured by arranging and combining a flight screwshaped forward flight piece that transports raw materials in a forward direction, a reverse flight piece that transports raw materials in a reverse direction, a kneading piece that kneads raw materials, etc. in an order and at positions according to characteristics of the raw materials. Note that although one screw 4 is illustrated in FIG. 2, in practice, two screws 4 are rotatably inserted into an inner hole of the cylinder 3 in a state of being meshed with each other.

<Simulation method>

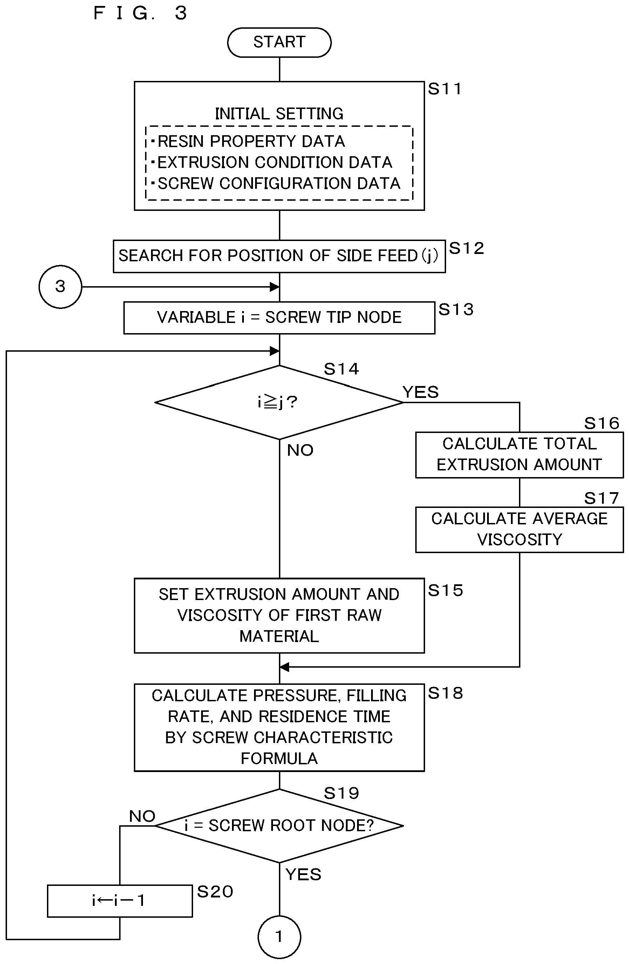

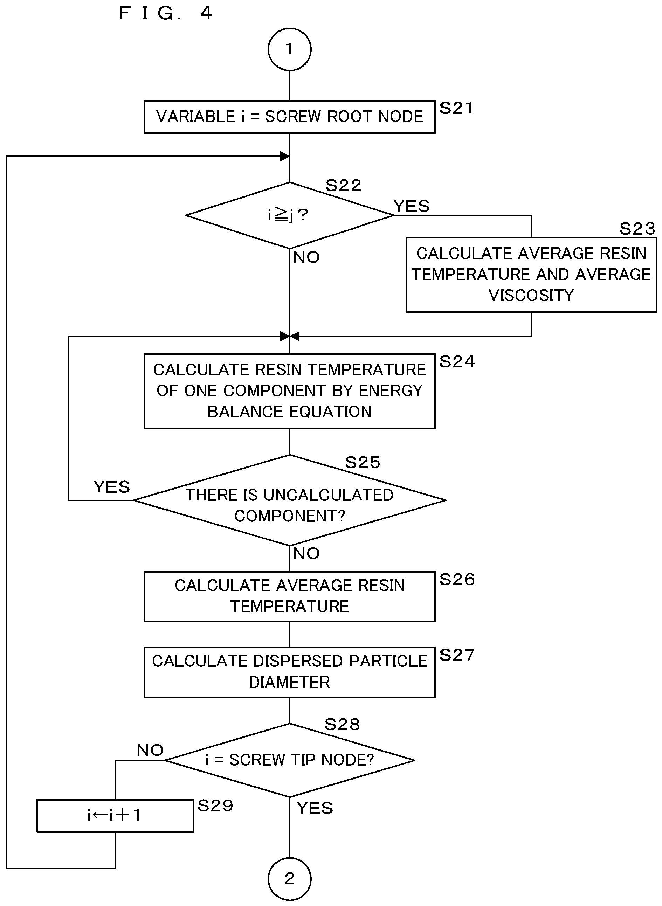

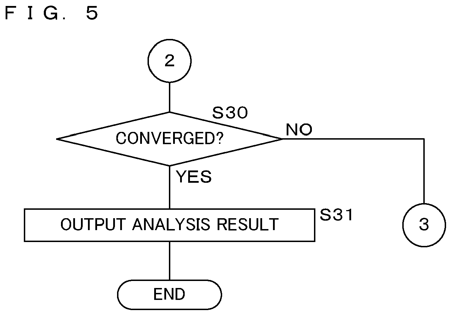

FIGS. 3 to 5 are flowcharts illustrating a simulation method according to the present embodiment. Hereinafter, a simulation method of a kneading process in which two types of raw materials having different physical properties are mixed will be described. The first raw material and the second raw material are set as resin raw materials having different characteristics.

The calculation unit 11 of the activated simulation device 1 first performs initial settings (step S11). Specifically, the calculation unit 11 acquires a viscosity model and a melting point of each of a plurality of raw materials injected into the kneading extruder, and resin property data indicating physical properties such as density, specific heat, and thermal conductivity of a solid and a melted body. In addition, the calculation unit 11 acquires extrusion condition data such as an extrusion amount, a screw rotation speed, a raw material resin temperature, a tip resin pressure, and a cylinder temperature of a raw material. Further, the calculation unit 11 acquires screw configuration data indicating positions and arrangement of a plurality of types of screw pieces, a screw diameter, a cylinder diameter, a position of the hopper 31 in a longitudinal direction of the screw 4, a position of the side feed 32, etc. Note that the calculation unit 11 or the input unit 13 that executes the process of step S11 functions as an acquisition unit that acquires at least characteristics of the first raw material and characteristics of the second raw material to be injected into the kneading extruder.

Next, the calculation unit 11 searches for the position of the side feed 32 based on initially set data (step S12). As illustrated in FIG. 2, a position of the screw 4 in the longitudinal direction is represented by a variable i. A value of the variable i corresponding to the position of the screw 4 in the longitudinal direction corresponding to the position of the side feed 32 is set to "j". The value of the variable i increases from a screw root node 4a to a screw tip node 4b. The screw root node 4a is a node at a tip of the screw 4 on the left side in FIG. 2, and the screw tip node 4b is a node at a tip of the screw 4 on the right side in FIG. 2.

Next, the calculation unit 11 substitutes the variable i with a numerical value representing a position of the screw tip node 4b (step S13).

Then, the calculation unit 11 determines whether or not the variable i is equal to or greater than the value j indicating the position of the side feed 32 (step S14). When it is determined that the variable i is less than the value j (step $S_{14}$: NO), the calculation unit 11 sets the extrusion amount and viscosity of the first raw material assuming that only the first raw material is present (step S15). When it is determined that the variable i is equal to or greater than the value j (step S14: YES), the calculation unit 11 sets the total extrusion amount of the first and second raw materials as the extrusion amount (step S16). Further, the calculation unit 11 sets average viscosity of a mixture of the first and second raw materials as the viscosity (step S17).

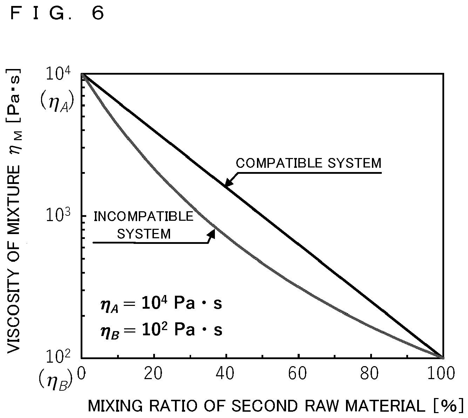

FIG. 6 is a graph illustrating a relationship between a mixing ratio and viscosity of a mixture. A horizontal axis indicates a mixing ratio of the second raw material, that is, a ratio of the second raw material to the mixture, and a vertical axis indicates the viscosity of the mixture of the first and second raw materials.

The viscosity of the mixture in a compatible system is represented by the following Equation (1).
[Equation 1]

$$log\eta_M = C_A log\eta_A + C_B log\eta_B \cdots \ (1)$$

where

$\eta_M$ : viscosity of mixture
$\eta_A$ : viscosity of first raw material
$\eta_B$ : viscosity of second raw material
$C_A$ : mixing ratio of first raw material
$C_B$ : mixing ratio of second raw material

The viscosity of the mixture in an incompatible system is represented by the following Equation (2). The meaning of each variable is the same as that in the above Equation (1).
[Equation 2]

$$log\eta_M = \frac{log\eta_A \times log\eta_B}{C_A log\eta_A + C_B log\eta_B} \quad \cdots \ (2)$$

Next, the calculation unit 11 calculates the pressure, the filling rate, and the residence time by a screw characteristic formula (step S18). When the variable i is less than j, the calculation unit 11 calculates the pressure, the filling rate, and the residence time using the extrusion amount and viscosity of the first raw material. When the variable i is equal to or greater than j, the pressure, the filling rate, and the residence time are macroscopically calculated using the total extrusion amount and average viscosity of the mixture calculated in steps S16 and S17.

Note that the pressure, the filling rate, and the residence time calculated in step S18 correspond to a second physical quantity according to this aspect.

The screw characteristic formula is represented by Equation (3) below. When the variable i is less than j, the extrusion amount Q and the viscosity $\eta$M are the extrusion amount and the viscosity of the first raw material. When the variable i is equal to or greater than j, the extrusion amount Q is the total extrusion amount of the first raw material and the second raw material, and the viscosity $\eta$M is the average viscosity of the mixture of the first raw material and the second raw material.
[Equation 3]

$$\Delta P = \frac{(\alpha - \bar{Q})}{\beta} \bar{L} \eta_M N_s \cdots \ (3)$$

where

$$\bar{Q} = \frac{Q}{N_s D^3}, \bar{L} = \frac{L}{D}$$

$\Delta P$ : pressure loss
$Q$ : extrusion amount
$\alpha$ : screw characteristic parameter (coefficient of traction current of screw)
$\beta$ : screw characteristic parameter (coefficient of pressure current of screw)
$L$ : screw length
$\eta_M$ : viscosity of mixture
$N_s$ : rotation speed

*D* : cylinder diameter

A pressure P at a position represented by the variable i may be calculated from a pressure loss ΔP and a known tip resin pressure P0.

The filling rate is expressed by the following Equation (4).

[Equation 4]

$$Fill = \bar{Q} / \alpha \quad \cdots \quad (4)$$

where

*Fill* :    filling rate

a :    screw characteristic parameter

The residence time is represented by the following Equation (5).

[Equation 5]

$$T = V \times Fill / Q \quad \cdots (5)$$

where

*T* :    residence time
*V* :    flow path capacity
*Fill* :    filling rate

Then, the calculation unit 11 determines whether or not the variable i is a value indicating the screw root node 4a (step S19). When it is determined that the variable i is not a value indicating the screw root node 4a (step S19: NO), the calculation unit 11 decrements the variable i by 1 (step S20), and returns the process to step S14.

When it is determined that the variable i is a value indicating the screw root node 4a (step S19: YES), the calculation unit 11 substitutes the variable i with a numerical value representing the position of the screw root node 4a (step S21). Note that the process of step S21 may be omitted.

Next, the calculation unit 11 determines whether or not the variable i is equal to or greater than the value j indicating the position of the side feed 32 (step S22). When it is determined that the variable i is equal to or greater than the value j (step S22: YES), the calculation unit 11 calculates an average temperature (hereinafter referred to as an average resin temperature) and the average viscosity of the first and second resins (step S23). The average resin temperature may be calculated by a weighted average using the mixing ratio of the first raw material and the second raw material. The average viscosity is calculated by the above Equation (1) or (2). The average resin temperature calculated here is used to calculate "total energy given to the raw material from the cylinder" in Equation (6) described later. The average viscosity is used to calculate "shearing energy given to the raw material from the screw" in Equation (7) described later.

When it is determined in step S22 that the variable i is less than the value j (step S22: NO), or when the calculation unit 11 completes the process of step S23, the calculation unit 11 calculates a resin temperature of one component by an energy balance equation (step S24).

When the variable i is equal to or greater than the value j, and a plurality of raw materials is present, the calculation unit 11 calculates one component selected from the plurality of raw materials, that is, a resin temperature of each of the plurality of raw materials. When the variable i is less than the value j, and only the first raw material is present, the calculation unit 11 calculates a resin temperature of the first raw material.

Note that the resin temperature calculated in step S24 corresponds to a first physical quantity according to this aspect.

Hereinafter, a resin temperature of the mixture of the first raw material and the second raw material will be described. Thermal energy input from the cylinder 3 to each of the first and second raw materials is represented by the following Equation (6).

[Equation 6]

$$ENB_{total} = ENB_A + ENB_B \quad \cdots \quad (6)$$

$$ENB_A = ENB_{total} \times x$$

$$ENB_B = ENB_{total} \times (1 - x)$$

where

$ENB_{total}$ :  total thermal energy given from cylinder to raw material
$ENB_A$ :  thermal energy given from cylinder to first raw material
$ENB_B$ :  thermal energy given from cylinder to second raw material
$x$ :  mixing ratio of first raw material

Shearing energy input from the screw 4 to each of the first and second raw materials is represented by the following Equation (7).
[Equation 7]

$$ENA_{total} = ENA_A + ENA_B \quad \cdots \quad (7)$$

$$ENA_A = ENA_{total} \times x$$

$$ENA_B = ENA_{total} \times (1 - x)$$

where

$ENA_{total}$ :  shearing energy given from screw to raw material
$ENA_A$ :  shearing energy given from screw to first raw material
$ENA_B$ :  shearing energy given from screw to second raw material
$x$ :  mixing ratio of first raw material

Temperature changes of the first and second raw materials are represented by the following Equations (8-1) and (8-2) in consideration of the energy balance. The calculation unit 11 may calculate each of the temperatures of the first and second raw materials using a resin temperature under an initial condition and the following Equations (8-1) and (8-2).
[Equation 8]

$$\Delta T_A = \frac{ENB_A + ENA_A}{Q_A \times C_{p_A}} \quad \cdots \quad (8-1)$$

$$\Delta T_B = \frac{ENB_B + ENA_B}{Q_B \times C_{p_B}} \quad \cdots \quad (8-2)$$

where

$\Delta T_A$ : temperature change amount of first raw material
$\Delta T_B$ : temperature change amount of second raw material
$Q_A$ : extrusion amount of first raw material
$Q_B$ : extrusion amount of second raw material
$C_{pA}$ : specific heat of first raw material
$C_{pB}$ : specific heat of second raw material

The calculation unit 11 completing the process of step S24 determines whether or not there is a component for which the resin temperature has not been calculated in step S24 (step S25). When it is determined that there is an uncalculated component (step S25: YES), the calculation unit 11 returns the process to step S24 and calculates a resin temperature for a raw material of another component.

When it is determined that there is no uncalculated component (step S25: NO), the calculation unit 11 calculates an average resin temperature of the mixture based on the resin temperature of each raw material calculated in step S24 (step S26).

That is, the resin temperature of the mixture is not macroscopically calculated using the average value of the physical properties of the mixture. The resin temperatures of the respective raw materials are microscopically calculated on the assumption that each raw material first exists as a simple substance, and an average value of the calculated resin temperatures of the respective raw materials is calculated. The resin temperature is more accurately calculated by being microscopically calculated rather than being macroscopically calculated, and the physical quantity may be calculated.

In the above description, a method of calculating the resin temperature in another component system has been described in steps S24 to S26. However, when the variable i is less than the value j, and only the first raw material is present, similar calculation may be performed by setting the mixing ratio to 1 and ignoring the second raw material.

Next, the calculation unit 11 calculates a dispersed particle diameter from a viscosity ratio and interfacial tension (step S27). Note that the dispersed particle diameter calculated in step S27 corresponds to the second physical quantity according to this aspect. The dispersed particle diameter is a diameter of particles made of the second raw material dispersed in the melted first raw material, or a diameter of particles made of the first raw material dispersed in the melted second raw material. The dispersed particle diameter is represented by, for example, the following Equation (9).

[Equation 9]

$$D = \frac{C\sigma}{\dot{\gamma}\eta_m} \left( \frac{\eta_m}{\eta_d} \right) \quad \cdots \quad (9)$$

where

$D$ : dispersed particle diameter
$C$ : constant
$\sigma$ : interfacial tension
$\dot{\gamma}$ : shearing speed
$\eta_m$ : viscosity of matrix resin
$\eta_d$ : viscosity of domain resin

Further, the dispersed particle diameter may be expressed by the following Equation (10).
[Equation 10]

$$D = \frac{4\sigma}{\dot{\gamma}\eta_m} \left( \frac{\eta_d}{\eta_m} \right)^{0.84} \qquad \left( \frac{\eta_d}{\eta_m} \geq 1 \right)$$

$$D = \frac{4\sigma}{\dot{\gamma}\eta_m} \left( \frac{\eta_d}{\eta_m} \right)^{-0.84} \qquad \left( \frac{\eta_d}{\eta_m} < 1 \right) \quad \cdots \quad (10)$$

Further, the dispersed particle diameter may be expressed by Equation (11) below. In particular, in Equation (11) below, the viscosity of the mixture of the first raw material and the second raw material is used.
[Equation 11]

$$D = \frac{4\sigma}{\dot{\gamma}\eta_b}\left(\frac{\eta_d}{\eta_b}\right)^{0.84}[1 - 4(\phi_d\phi_m)^{0.8}] \quad \left(\frac{\eta_d}{\eta_m} \geq 1\right)$$

$$D = \frac{4\sigma}{\dot{\gamma}\eta_b}\left(\frac{\eta_d}{\eta_b}\right)^{-0.84}[1 - 4(\phi_d\phi_m)^{0.8}] \quad \left(\frac{\eta_d}{\eta_m} < 1\right) \quad \cdots \quad (1\ 1)$$

where

$\phi_m$ : mixing ratio of matrix resin
$\phi_d$ : mixing ratio of domain resin
$\eta_b$ : viscosity of mixture

Then, the calculation unit 11 determines whether or not the variable i is a value indicating the screw tip node 4b (step S28). When it is determined that the variable i is not the value indicating the screw tip node 4b (step S28: NO), the calculation unit 11 increments the variable i by 1 (step S29), and returns the process to step S22.

When it is determined that the variable i is the value indicating the screw tip node 4b (step S28: YES), the calculation unit 11 determines whether or not a simulation result has converged (step S30). When it is determined that the simulation results have not converged (step S30: NO), the calculation unit 11 returns the process to step S13 and repeatedly executes the processes of steps S13 to S29.

When it is determined that the simulation result has converged (step S30: YES), the calculation unit 11 outputs an analysis result to the output unit 14 (step S31), and ends the process.

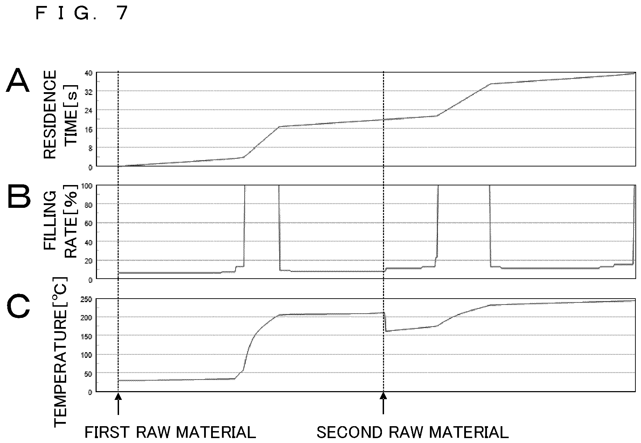

FIG. 7 is a graph illustrating a simulation result of a kneading process. FIG. 7 illustrates an example of the case where polyethylene (PE: Polyethylene) at about 30°C is injected as the first raw material into the kneading extruder at 100 kg/hour, and polypropylene (PP: Polypropylene) at about 30°C is injected as the second raw material into the kneading extruder at the side feed 32 at a mixing ratio of 30 wt% from a position of L/D = 26.25.

A horizontal axis of each of the graphs illustrated in FIGS. 7A to 7C indicates the variable i, that is, the position of the screw 4 in the longitudinal direction. FIG. 7A illustrates the residence time, FIG. 7B illustrates the filling rate, and FIG. 7C illustrates the temperature. As illustrated in FIG. 7B, at the position where the second raw material is injected, the filling rate is increased due to an increase in the extrusion amount. Further, at the position where the second raw material is injected, a resin temperature of the entire mixture is lowered, and is raised to a resin temperature according to the characteristics of the mixture by a subsequent kneading process.

In this way, the simulation device 1 according to the present embodiment may calculate the residence time, the filling rate, and the temperature of the mixture of the first and second raw materials, and output an analysis result.

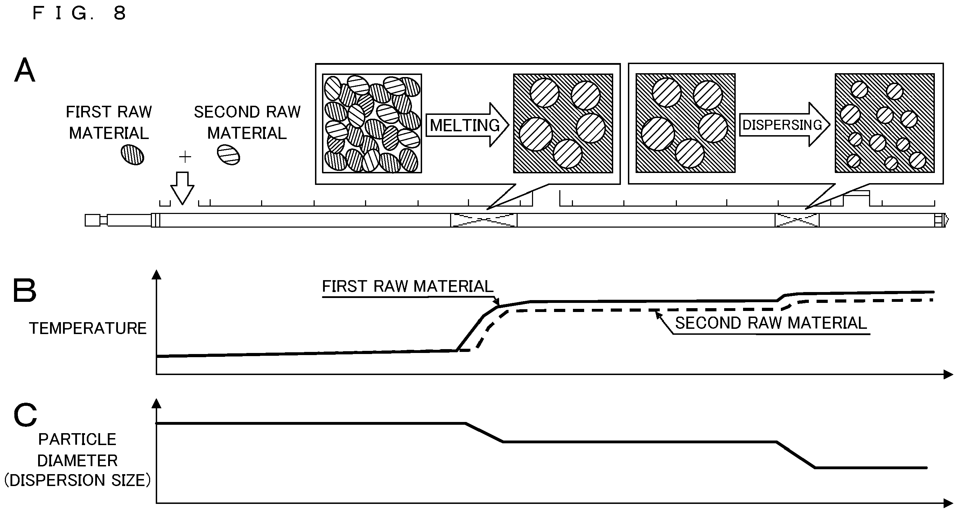

FIG. 8 is a graph illustrating a resin temperature and a dispersed particle diameter of each raw material in the kneading process. As illustrated in FIG. 8A, the first raw material and the second raw material are injected from a portion corresponding to the screw tip node 4b. The first and second raw materials are kneaded at a portion marked with X. FIG. 8B illustrates the resin temperatures of the first raw material and the second raw material, and FIG. 8C illustrates a particle diameter (dispersion size) of the dispersed second raw material. In FIG. 8B, a solid line indicates a temperature of a first raw material component, and a broken line indicates a temperature of a second raw material component.

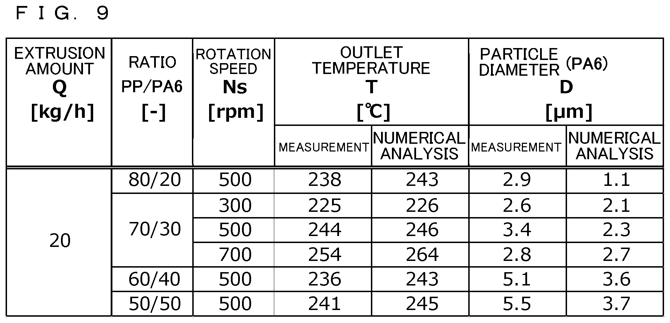

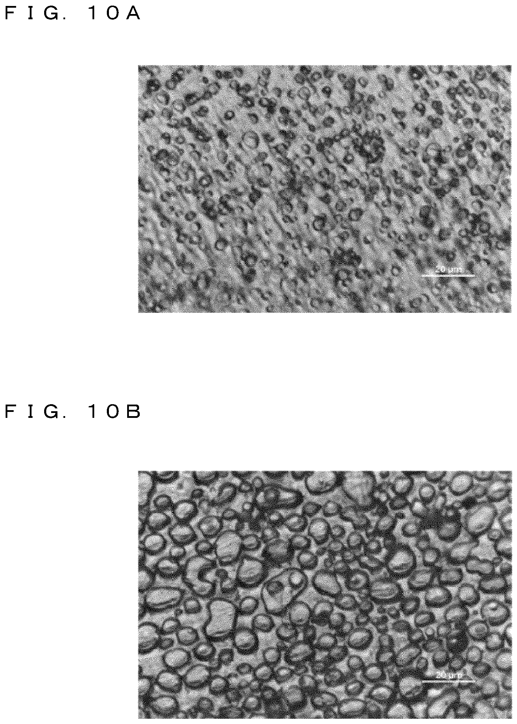

FIG. 9 is a chart illustrating a comparison result between a measured value and a simulation result. FIG. 10A and FIG. 10B are optical micrographs illustrating dispersed states of resin raw materials, respectively. A total extrusion amount is 20 kg/h. The first raw material is polypropylene with a melt index MI = 7. The second raw material is polyamide 6 (PA6: Polyamide) with relative viscosity of 2.45. A ratio of the first raw material to the second raw material was set to 80/20, 70/30, 60/40, and 50/50, the rotation speed of the screw 4 was set to 300 rpm, 500 rpm, and 700 rpm, and an experiment and simulation using actual machines were conducted. FIG. 9 illustrates an experimental result and a simulation result of the resin temperature and the dispersed particle diameter at an outlet of the kneading extruder.

FIG. 10A is an optical micrograph of a mixture obtained by a kneading process in which the ratio of the first raw material to the second raw material is 80/20 and the rotation speed of the screw 4 is 500 rpm. FIG. 10B is an optical micrograph of a mixture obtained by a kneading process in which the ratio of the first raw material to the second raw material is 50/50 and the rotation speed of the screw 4 is 500 rpm.

As illustrated in the chart of FIG. 9, a simulation result of an outlet temperature is generally excellent, and a difference from an outlet temperature measured using the actual machine is a maximum of 10°C. With regard to the dispersed particle diameter, when compared to results of ratios 80/20 and 50/50 of the first raw material to the second raw material, it can be seen that a simulation result reproduces the tendency of the dispersed particle diameter observed using the actual machine.

According to the simulation device 1, the simulation method, and the simulation program 12a according to the present embodiment configured in this way, it is possible to calculate a predetermined physical quantity in a kneading process of a plurality of types of raw materials.

Further, by properly using a micro-calculation method and a macro-calculation method depending on the type of physical quantity to be calculated, the kneading process of the kneading extruder may be simulated more accurately.

It is possible to simulate a kneading process of a kneading extruder having the hopper 31 into which the first raw material is injected and the side feed 32 into which the second raw material is injected provided at different positions.

Furthermore, by microscopically calculating the temperature of the mixture, the temperature of the mixture may be accurately calculated.

Furthermore, by macroscopically calculating the dispersed particle diameter of the mixture, the dispersed particle diameter of the mixture may be accurately calculated.

Note that, in the present embodiment, an example in which two types of resin raw materials are kneaded has been mainly described. However, the invention is applicable to the case where a filler such as glass fiber, carbon fiber, or magnetic powder, which is a second raw material, is kneaded in the resin raw material which is the first raw material.

The viscosity of the mixture of the resin raw material and the filler may be calculated using Mooney equation (Mooney, M.: J. Colloid Sci., 6, 162 (1951)), Chong equation (Chong, J. S.: J. Appl. Polymer Sci., 15, 2007 (1971)), Eilers equation (Eilers, von H.: Colloid and Polymer Sci., 97, 313 (1941)), etc.

The Mooney equation is expressed by the following Equation (12).

[Equation 12]

$$\eta = \eta_0 \exp\left[\frac{2.5\phi}{1 - \phi/\phi_M}\right] \cdots \quad (1\,2)$$

where

$\eta_0$ : coefficient
$\phi$ : filler volume fraction
$\phi_M$ : filler closest volume fraction($0.52 \leq \phi_M \leq 0.74$)

The Chong equation is expressed by the following Equation (13).

[Equation 13]

$$\eta = \eta_0\left[1 + \frac{0.75(\phi/\phi_M)}{1 - (\phi/\phi_M)}\right]^2 \cdots \quad (1\,3)$$

The Eilers equation is expressed by the following Equation (14).

[Equation 14]

$$\eta = \eta_0\left[1 + \frac{1.25\phi}{1 - (\phi/\phi_M)}\right]^2 \cdots \quad (1\,4)$$

where

$\phi_M$ = 0.74 : particle
$\phi_M$ = 0.29 : fiber

Further, even though the simulation in which the first and second raw materials are injected from different positions has been described, the invention is applicable to the case where the first and second raw materials are injected from the same position.

[Description of Reference Numerals]

1      Simulation device

2        Recording medium
3        Cylinder
4        Screw
4a       Screw root node
4b       Screw tip node
11       Calculation unit
12       Storage unit
12a      Simulation program
13       Input unit (acquisition unit)
14       Output unit
31       Hopper (first injection portion)
32       Side feed (second injection portion)

**Claims**

1. A simulation device for calculating a predetermined physical quantity in a kneading extruder, the simulation device comprising:

   an acquisition unit configured to acquire at least a characteristic of a first raw material and a characteristic of a second raw material, the first raw material and the second raw material being injected into the kneading extruder; and
   a calculation unit configured to calculate a physical quantity of a mixture of the first raw material and the second raw material based on the characteristics of the first raw material and the second raw material acquired by the acquisition unit.

2. The simulation device according to claim 1, wherein the calculation unit:

   calculates a first physical quantity related to the first raw material based on the characteristic of the first raw material;
   calculates a first physical quantity related to the second raw material based on the characteristic of the second raw material;
   calculates a first physical quantity of the mixture based on the first physical quantity related to the first raw material and the first physical quantity related to the second raw material; and
   calculates a second physical quantity of the mixture based on an average value of the characteristics of the first raw material and the second raw material.

3. The simulation device according to claim 2, wherein:

   the kneading extruder, which is a simulation object, has a first injection portion into which the first raw material is injected and a second injection portion into which the second raw material is injected, the first injection portion is located on a root side of a cylinder into which a screw is rotatably inserted, and the second injection portion is located on an outlet side of the cylinder with respect to the first injection portion, and
   the calculation unit:

   searches for a position of the second injection portion in a longitudinal direction of the screw;
   calculates a first physical quantity on a root side of the second injection portion based on the characteristic of the first raw material and calculates a first physical quantity of the mixture on a tip side of the second injection portion; and
   calculates a second physical quantity on the root side of the second injection portion based on the characteristic of the first raw material and calculates a second physical quantity of the mixture on the tip side of the second injection portion.

4. The simulation device according to claim 2 or 3, wherein the first physical quantity includes a temperature of the mixture.

5. The simulation device according to any one of claims 2 to 4, wherein the second physical quantity includes a particle diameter of the first raw material or the second raw material dispersed in the mixture.

6. A simulation method for calculating a predetermined physical quantity in a kneading extruder, the simulation method comprising:

acquiring at least a characteristic of a first raw material and a characteristic of a second raw material, the first raw material and the second raw material being injected into the kneading extruder; and
calculating a physical quantity of a mixture of the first raw material and the second raw material based on the acquired characteristics of the first raw material and the second raw material.

7. A simulation program for causing a computer to execute a process of calculating a predetermined physical quantity in a kneading extruder, the simulation program causing the computer to execute processes of

acquiring at least a characteristic of a first raw material and a characteristic of a second raw material, the first raw material and the second raw material being injected into the kneading extruder; and
calculating a physical quantity of a mixture of the first raw material and the second raw material based on the acquired characteristics of the first raw material and the second raw material.

F I G. 1

INITIAL
CONDITIONS → INPUT UNIT `13` → CALCULATION UNIT `11` → OUTPUT UNIT `14` → ANALYSIS RESULT
(PREDETERMINED
PHYSICAL QUANTITY)

STORAGE UNIT `12`

SIMULATION PROGRAM `12a`

`1`

`2`

EP 4 166 297 A1

F I G. 2

FIG. 3

```
                    ┌─────────────┐
                    │    START    │
                    └─────────────┘
                           │
        ┌──────────────────────────────────────┐  S11
        │          INITIAL SETTING             │
        │  ┌─────────────────────────────────┐ │
        │  │ ·RESIN PROPERTY DATA            │ │
        │  │ ·EXTRUSION CONDITION DATA       │ │
        │  │ ·SCREW CONFIGURATION DATA       │ │
        │  └─────────────────────────────────┘ │
        └──────────────────────────────────────┘
                           │
        ┌──────────────────────────────────────┐ S12
        │ SEARCH FOR POSITION OF SIDE FEED(j)   │
        └──────────────────────────────────────┘
   ┌───┐                   │
   │ 3 │───────────┐       │
   └───┘           ▼       │
        ┌──────────────────────────────────┐ S13
        │   VARIABLE i = SCREW TIP NODE     │
        └──────────────────────────────────┘
                           │
                           ▼
                    ╱─────────────╲  S14       YES
                   ╱   i ≧ j ?     ╲──────────────┐
                   ╲               ╱              │
                    ╲─────────────╱               ▼
                         │ NO          ┌──────────────────────┐ S16
                         │             │  CALCULATE TOTAL      │
                         │             │  EXTRUSION AMOUNT     │
                         │             └──────────────────────┘
                         │                        │
                         │             ┌──────────────────────┐ S17
                         │             │  CALCULATE AVERAGE    │
                         │             │  VISCOSITY            │
                         │             └──────────────────────┘
                         ▼                        │
        ┌──────────────────────────────┐ S15      │
        │ SET EXTRUSION AMOUNT AND      │          │
        │ VISCOSITY OF FIRST RAW        │          │
        │ MATERIAL                      │          │
        └──────────────────────────────┘          │
                         │◄───────────────────────┘
                         ▼
        ┌──────────────────────────────┐ S18
        │ CALCULATE PRESSURE, FILLING   │
        │ RATE, AND RESIDENCE TIME      │
        │ BY SCREW CHARACTERISTIC       │
        │ FORMULA                       │
        └──────────────────────────────┘
                         │
                         ▼
          NO      ╱─────────────────────╲  S19
        ┌─────────┤ i = SCREW ROOT NODE? │
        │         ╲─────────────────────╱
        │                   │ YES
   ┌─────────┐ S20           ▼
   │ i←i−1   │            ┌─────┐
   └─────────┘            │  1  │
        │                 └─────┘
        └─────────────────┘
```

F I G .  4

```
                        ( 1 )
                          |
      ┌───────────────────┼───────────────────────┐
      │   VARIABLE i = SCREW ROOT NODE    │ S21
      └───────────────────┬───────────────────────┘
      │                   ▼
      │                 S22
      │           ◇ i ≧ j ? ◇ ──── YES ──────┐
      │                 │                     │
      │                NO                     ▼            S23
      │                 │       ┌──────────────────────────┐
      │                 │       │ CALCULATE AVERAGE RESIN  │
      │                 │       │ TEMPERATURE AND AVERAGE  │
      │                 │       │        VISCOSITY         │
      │                 │       └────────────┬─────────────┘
      │                 ▼◄───────────────────┘
      │       ┌──────────────────────────┐  S24
      │       │ CALCULATE RESIN TEMPERATURE │
      │       │ OF ONE COMPONENT BY ENERGY  │
      │       │    BALANCE EQUATION         │
      │       └────────────┬──────────────┘
      │                    ▼       S25
      │  YES ──── ◇ THERE IS UNCALCULATED ◇
      │                ◇ COMPONENT? ◇
      │                    │
      │                   NO
      │                    ▼
      │       ┌──────────────────────────┐  S26
      │       │ CALCULATE AVERAGE RESIN   │
      │       │      TEMPERATURE          │
      │       └────────────┬──────────────┘
      │                    ▼
      │       ┌──────────────────────────┐  S27
      │       │ CALCULATE DISPERSED PARTICLE │
      │       │        DIAMETER           │
      │       └────────────┬──────────────┘
      │                    ▼       S28
      │  NO ──── ◇ i = SCREW TIP NODE? ◇
      │     │              │
      │     ▼             YES
      │  ┌─────────┐ S29    ▼
      └──┤ i←i+1   │      ( 2 )
         └─────────┘
```

F I G. 5

F I G. 6

F I G. 7

A  RESIDENCE TIME[s]

B  FILLING RATE[%]

C  TEMPERATURE[°C]

FIRST RAW MATERIAL          SECOND RAW MATERIAL

F I G. 8

A

FIRST RAW
MATERIAL

SECOND RAW
MATERIAL

+

MELTING

DISPERSING

B

TEMPERATURE

FIRST RAW MATERIAL

SECOND RAW MATERIAL

C

PARTICLE
DIAMETER
(DISPERSION SIZE)

EP 4 166 297 A1

F I G. 9

| EXTRUSION AMOUNT Q [kg/h] | RATIO PP/PA6 [-] | ROTATION SPEED Ns [rpm] | OUTLET TEMPERATURE T [℃] | | PARTICLE DIAMETER (PA6) D [μm] | |
|---|---|---|---|---|---|---|
| | | | MEASUREMENT | NUMERICAL ANALYSIS | MEASUREMENT | NUMERICAL ANALYSIS |
| 20 | 80/20 | 500 | 238 | 243 | 2.9 | 1.1 |
| | 70/30 | 300 | 225 | 226 | 2.6 | 2.1 |
| | | 500 | 244 | 246 | 3.4 | 2.3 |
| | | 700 | 254 | 264 | 2.8 | 2.7 |
| | 60/40 | 500 | 236 | 243 | 5.1 | 3.6 |
| | 50/50 | 500 | 241 | 245 | 5.5 | 3.7 |

FIG. 10A

FIG. 10B

**INTERNATIONAL SEARCH REPORT**

| | International application No. |
|---|---|
| | PCT/JP2021/021138 |

**A. CLASSIFICATION OF SUBJECT MATTER**
Int.Cl. B29B7/48(2006.01)i, B29B7/72(2006.01)i, B29C48/285(2019.01)i, B29C48/40(2019.01)i, B29C48/92(2019.01)i
FI: B29B7/72, B29B7/48, B29C48/40, B29C48/285, B29C48/92
According to International Patent Classification (IPC) or to both national classification and IPC

**B. FIELDS SEARCHED**

Minimum documentation searched (classification system followed by classification symbols)
Int.Cl. B29B7/00-7/94, B29C48/00-48/96

Documentation searched other than minimum documentation to the extent that such documents are included in the fields searched
Published examined utility model applications of Japan     1922–1996
Published unexamined utility model applications of Japan     1971–2021
Registered utility model specifications of Japan     1996–2021
Published registered utility model applications of Japan     1994–2021

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X<br>A | JP 9-29819 A (ASAHI KASEI KOGYO CO., LTD.) 04 February 1997 (1997-02-04), claims, paragraphs [0015]-[0069], fig. 1-11 | 1-4, 6-7<br>5 |
| X<br>A | JP 2012-45866 A (POLYPLASTICS CO., LTD.) 08 March 2012 (2012-03-08), claims, paragraphs [0011]-[0109], fig. 1-3 | 1, 6-7<br>2-5 |

☐  Further documents are listed in the continuation of Box C.          ☒  See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| 02 July 2021 | 13 July 2021 |

| Name and mailing address of the ISA/<br>Japan Patent Office<br>3-4-3, Kasumigaseki, Chiyoda-ku,<br>Tokyo 100-8915, Japan | Authorized officer<br><br>Telephone No. |

Form PCT/ISA/210 (second sheet) (January 2015)

EP 4 166 297 A1

| | | |
|---|---|---|
| **INTERNATIONAL SEARCH REPORT** Information on patent family members | International application No. PCT/JP2021/021138 | |

| | | |
|---|---|---|
| JP 9-29819 A | 04 February 1997 | (Family: none) |
| JP 2012-45866 A | 08 March 2012 | US 2014/0149089 A1 claims, paragraphs [0037]-[0144], fig. 1-3 EP 2610041 A1 |

Form PCT/ISA/210 (patent family annex) (January 2015)

24

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2004148722 A

**Non-patent literature cited in the description**

- **MOONEY, M.** *J. Colloid Sci.,* 1951, vol. 6, 162
- **CHONG, J. S.** *J. Appl. Polymer Sci.,* 1971, vol. 15, 2007
- **EILERS, VON H.** *Colloid and Polymer Sci.,* 1941, vol. 97, 313